# EUROPÄISCHE PATENTSCHRIFT

(11) **EP 0 562 354 B1**
(45) Veröffentlichungstag und Bekanntmachung des Hinweises auf die Patenterteilung: **19.01.2000**
(21) Anmeldenummer: 93103760.0
(22) Anmeldetag: 09.03.1993
(51) Int. Cl.: H01L 29/08, H01L 27/02, H01L 27/06

(54) **Integrierte Schaltungsanordnung**
Integrated circuit device
Dispositif de circuit intégré

(30) Priorität: 24.03.1992 DE 4209523
(43) Veröffentlichungstag der Anmeldung: 29.09.1993
(73) Patentinhaber: SIEMENS AKTIENGESELLSCHAFT, 80333 München (DE)
(72) Erfinder: Feldtkeller, Martin, Dipl.-Ing., W-8000 München 80 (DE)

(56) Entgegenhaltungen:
- EP-A- 0 040 125
- EP-A- 0 261 556
- FR-A- 2 233 711
- PATENT ABSTRACTS OF JAPAN vol. 11, no. 346 (E-556)(2793) 12. November 1987 & JP-A-62 125 659 ( TOSHIBA ) 6. Juni 1987

## Beschreibung

Die Erfindung betrifft eine integrierte Schaltungsanordnung zur Verminderung von Minoritätsträgerinjektion gemäß dem Oberbegriff des Anspruchs 1.

Werden von Leistungsbauelementen in integrierten Schaltungen induktive oder kapazitive Lasten gespeist, so entstehen beim Schalten derartiger Bauelemente Ströme, die beispielsweise über Freilaufdioden abgeleitet werden müssen. Das Substrat derartiger Schaltungsanordnungen ist mit Masse verbunden. Das Ableiten des Stromes erfolgt über eine Freilaufdiode, deren Anode ebenfalls mit Masse verbunden ist. Wird die Last durch das Leistungsbauelement abgeschaltet, so muß der von der Last eingeprägte Strom über die Freilaufdiode abfließen. Fließt Strom durch die Freilaufdiode, so sinkt das Potential der Kathode unterhalb des Potentials des Substrats. Dabei können durch Minoritätsträgerinjektion der Kathode in das Substrat parasitäre Strukturen aktiviert werden, die zur Zerstörung oder Fehlfunktion der Schaltungsanordnung führen.

Derartige Effekte sind seit langem bekannt und z.B. in "Controlling Substrate Currents in Junction-Isolated IC's" von Robert J. Widlar, erschienen im IEEE Journal of solid-state circuits, Vol. 26, No. 8, August 1991, Seite 1090 ff. beschrieben. Darin ist z.B. auf Seite 1092, rechte Spalte beschrieben, daß zur Vermeidung eines derartigen Effekts eine das Leistungsbauelement umgebende Ringstruktur mit Masse zu verbinden ist.

Nachteil einer derartigen Anordnung ist, daß sie bei hohen Strömen nicht immer zufriedenstellend funktioniert, da die Ringstruktur den Substratstrom nicht vollständig aufnehmen kann.

Eine Schaltungsanordnung mit einer ringförmigen Struktur, die teilweise von einer Kollektorstruktur umgegeben ist, ist aus EP-A-0 261 556 bekannt.

Aufgabe der Erfindung ist es eine verbesserte Schaltungsanordnung zur Verminderung von Minoritätsträgerinjektion anzugeben.

Diese Aufgabe wird durch das Kennzeichen des Anspruchs 1 gelöst. Weiterbildungen sind Kennzeichen der Unteransprüche.

Vorteil der erfindungsgemäßen Anordnung ist, daß der vom Substrat gebildete Serienwiderstand für die Funktion der Anordnung mit ausgenutzt wird und der Spannungsabfall an diesem Widerstand zu einer Verminderung der Flußspannung führt.

Die Erfindung wird nachfolgend anhand von zwei Figuren näher erläutert.
- Figur 1: zeigt einen Querschnitt durch ein erfindungsgemäßes Halbleiterbauelement,
- Figur 2: zeigt ein Ersatzschaltbild der erfindungsgemäßen Schaltungsanordnung.

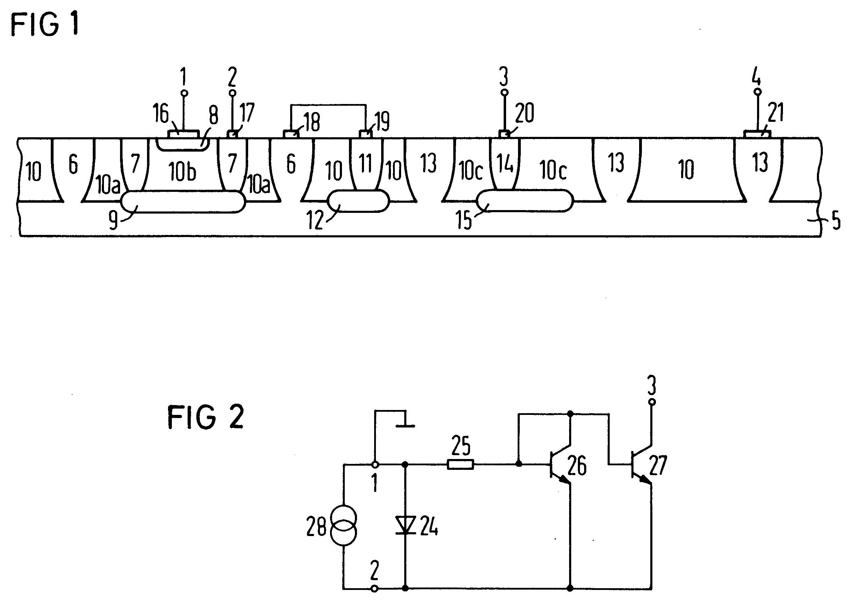

Der in Figur 1 gezeigte Querschnitt zeigt ein Substrat 5 vom p⁻-Leitungstyp, auf dem eine epitaktische Schicht 10 vom n⁻-Leitungstyp aufgebracht ist. Diese epitaktische Schicht 10 wird durch ringförmige p⁺-Isolationsstrukturen 6, 13 unterteilt, so daß sich innerhalb der ringförmigen Strukturen 6, 13 Bereiche 10 a, 10 b, 10 c ausbilden, innerhalb derer verschiedene Bauelemente realisiert werden können. So ist z.B. ein Leistungsbauelement mit einem n⁺-buried layer 9 und einer ringförmigen n⁺-Struktur 7, die vom buried layer 9 bis an die Oberfläche der epitaktischen Schicht 10 reicht, vorgesehen. Von der Oberfläche der epitaktischen Schicht 10 b reicht ein p-Bereich 8 in die epitaktische Schicht 10b. Durch diesen p-Bereich 8 und die es umgebenden n-Bereiche 7, 9, 10 b wird beispielsweise eine Leistungsdiode gebildet.

Die epitaktische Schicht innerhalb der ringförmigen Isolationsstruktur 6 teilt sich in zwei Bereiche 10 a und 10 b auf. Die ringförmig ausgebildete Isolationsstruktur 6 ist von einer weiteren ringförmig ausgebildeten Kollektorstruktur 11, 12 umgeben. Diese Struktur besteht aus einem n⁺-buried layer 12, an den sich bis zur Oberfläche der epitaktischen Schicht 10 eine n⁺-Zone 11 anschließt. Eine weitere p⁺-Isolationsstruktur 13 entsprechend der Isolationsstruktur 6 ist vorgesehen, die einen Bereich 10 c der epitaktischen Schicht 10 isoliert. Innerhalb dieser ist z.B. ein weiteres Bauelement realisiert, hier durch einen n⁺-buried layer 15 und einen weiteren n⁺- dotierten Bereich 14, der sich vom buried layer bis zur Oberfläche der epitaktischen Schicht 10 c erstreckt, dargestellt. Schließlich ist ein Kontakt zu der Oberfläche der Isolationsstruktur 13 vorgesehen, der zur Verbindung des Substrats 5 mit Masse dient.

Eine Anschlußklemme 1 ist vorgesehen, die über eine Kontaktierungsfläche 16 mit der p-Zone 8 verbunden ist. Weiterhin ist eine zweite Anschlußklemme 2 vorgesehen, die mit einer Kontaktierungsfläche 17 verbunden ist, welche oberhalb der ringförmigen Struktur 7 angeordnet ist. Die ringförmige Struktur 6 ist über eine Kontaktierungsfläche 18 mit der Kollektorstruktur 11 über eine an ihr angeordnete Kontaktierungsfläche 19 verbunden. Weiterhin ist eine Kontaktierungsfläche 20 vorgesehen, die oberhalb der n⁺-dotierten Zone 14 liegt und mit einer Anschlußklemme 3 verbunden ist. Die oberhalb der Zone 13 angebrachte Kontaktierungsfläche 21 dient zur Verbindung mit der Anschlußklemme 4.

Figur 2 zeigt das zugehörige Ersatzschaltbild. Mit 24 ist eine Freilaufdiode bezeichnet, die in Figur 1 durch die Bereiche 7, 8, 9 und 10 b realisiert wird. Die Anode der Freilaufdiode ist über die Anschlußklemme 1 mit Masse verbunden. Der vom Substrat 5 gebildete Widerstand ist mit 25 bezeichnet und verbindet die Anode der Diode 24 mit der Basis des durch die ringförmige Kollektorstruktur 11, 12, als Kollektor das Substrat 5 als Basis und den buried layer 9 als Emitter gebildeten Transistors 26. Dessen Basis ist mit seinem Kollektor verbunden. Der Emitter des Transistors 26 ist mit der Kathode der Anode 24 Anode 24 verschaltet. Der in Verbindung mit Substrat 5 als Basis und buried layer 9 der Freilaufdiode als Emitter sowie dem buried layer 15 als Kollektor gebildete laterale Transistor ist mit 27 bezeichnet. Dessen Basis ist mit der Basis des Transistors 26 im Ersatzschaltbild parallel geschaltet. In Figur 1 haben beiden Transistoren 26, 27 die gleiche Basis, welche durch das Substrat 5 gebildet wird und den gleichen Emitter, der durch den buried-layer gebildet wird. Im Ersatzschaltbild 2 ist der Emitter des Transistors 27 parallel zum Emitter des Transistors 26 geschaltet. Der Kollektor des Transistors 27 ist mit einer Anschlußklemme 3 verschaltet. Zusätzlich ist in Figur 2 eine Stromquelle 28 dargestellt, die über die Klemmen 1 und 2 parallel zur Diode 24 geschaltet ist.

Die Freilaufdiode 24, die einen Strom übernehmen soll, der die Kathode der Freilaufdiode 24 unter Masse zieht, ist erfindungsgemäß ganz oder teilweise von einer Ringwanne 11, 12 umgeben. Wesentlich ist, daß die ringförmige Isolation 6 und damit das Substrat in der Umgebung der Freilaufdiode nicht mit Masse, sondern vielmehr mit der ringförmigen Struktur 11, 12 verbunden sind. Ein Kontakt 21 zwischen Masse und Substrat ist erst in größerer Entfernung vorgesehen. Injiziert die Kathode der Freilaufdiode Minoritätsträger ins Substrat 5, so diffundiert ein Teil der Minoritätsträger in das n⁺-Gebiet der Ringwanne 11, 12 und führt dort zu einem Stromfluß, der das mit der Ringwanne 11, 12 verbundene Substrat 5 unter Masse zieht und so die für die Injektion der Minoritätsträger zur Verfügung stehende Flußspannung vermindert. Auf diese Weise entsteht eine Art Gegenkopplung, die die Injektion der Minoritätsträger vermindert.

Der Sperrstrom weiterer mit positiver Spannung verbundener n-Gebiete 15 aufgrund von Minoritätsträgern im Substrat 5 wird so auf ein tolerables Maß reduziert.

Eine Realisierung der erfindungsgemaßen Anordnung ist selbstverständlich auch mit anderen als den angegebenen Dotierungen möglich.

## Patentansprüche

1. Integrierte Schaltungsanordnung zur Verminderung der Injektion von Minoritätsträgern,
- bei der auf einem Halbleitersubstrat (5) eines ersten Leitungstyps eine epitaktische Schicht (10) eines zweiten Leitungstyps aufgebracht ist,
- bei der innerhalb der epitaktischen Schicht (10) mindestens eine ringförmige Struktur (6) vorgesehen ist, innerhalb derer ein Halbleiterbauelement (24; 7, 8, 9, 10b) angeordnet ist,
- wobei die ringförmige Struktur (6) von der ersten Oberflache des Halbleitersubstrats (5) bis zur Oberfläche der epitaktischen Schicht (10) reicht und vom ersten Leitungstyp ist,
- mit einer die ringförmige Struktur (6) zumindest teilweise, jedoch nicht ganz umgebende Kollektorstruktur (11, 12), die von der Oberflache des Halbleitersubstrats (5) bis zur Oberfläche der epitaktischen Schicht (10) reicht und vom zweiten Leitungstyp ist,
- bei der das Halbleitersubstrat (5) mit einem Bezugspotential verbunden ist,
**dadurch gekennzeichnet,** daß die Kollektorstruktur (11, 12) über eine an der Oberfläche angebrachte erste Kontaktfläche (19) mit einer an der Oberfläche angebrachten zweiten Kontaktfläche (18), die über die ringförmige Struktur (6) mit dem Substrat (5) verbunden ist, in unmittelbarer Nähe der Kollektorstruktur (11, 12) verbunden ist, und daß das Halbleitersubstrat (5) an einer von der ringförmigen Struktur (6) entfernten Stelle mit Masse verbunden ist.

2. Integrierte Schaltungsanordnung nach Anspruch 1,
**dadurch gekennzeichnet,**
daß die Kollektorstruktur (11, 12) stärker als die epitaktische Schicht (10) dotiert ist.

3. Integrierte Schaltungsanordnung nach einem der Ansprüche 1 bis 2,
**dadurch gekennzeichnet,**
daß die Kollektorstruktur aus einem buried layer (12), der zwischen Halbleitersubstrat (5) und epitaktischer Schicht (10) angeordnet ist und einer Zone (11) besteht, die vom buried layer bis zur Oberfläche der epitaktischen Schicht (10) reicht.

## Claims

1. Integrated circuit arrangement for reducing the injection of minority carriers,
- in which an epitaxial layer (10) of a second conduction type is applied on a semiconductor substrate (5) of a first conduction type,
- in which at least one annular structure (6) is provided within the epitaxial layer (10), a semiconductor component (24; 7, 8, 9, 10b) being arranged within the said structure,
- where the annular structure (6) extends from the first surface of the semiconductor substrate (5) as far as the surface of the epitaxial layer (10) and is of the first conduction type,
- with a collector structure (11, 12), which surrounds the annular structure (6) at least partly, but not entirely, extends from the surface of the semiconductor substrate (5) as far as the surface of the epitaxial layer (10) and is of the second conduction type,
- in which the semiconductor substrate (5) is connected to a reference potential,
characterized in that the collector structure (11, 12) is connected via a first contact area (19) provided on the surface to a second contact area (18) provided on the surface, the said second contact area being connected to the substrate (5) via the annular structure (6), in direct proximity to the collector structure (11, 12), and in that the semiconductor substrate (5) is connected to earth at a location remote from the annular structure (6).

2. Integrated circuit arrangement according to Claim 1,
characterized
in that the collector structure (11, 12) is doped more heavily than the epitaxial layer (10).

3. Integrated circuit arrangement according to one of Claims 1 to 2,
characterized
in that the collector structure comprises a buried layer (12), which is arranged between the semiconductor substrate (5) and the epitaxial layer (10), and a zone (11), which extends from the buried layer as far as the surface of the epitaxial layer (10).

## Revendications

1. Montage intégré pour diminuer l'injection de porteurs de charge,
- dans lequel il est déposé sur un substrat (5) semi-conducteur d'un premier type de conductivité, une couche (10) épitaxiale d'un second type de conductivité,
- dans lequel il est prévu à l'intérieur de la couche (10) épitaxiale au moins une structure (6) annulaire à l'intérieur de laquelle est monté un composant (24 ; 7, 8, 9, 10 b) à semi-conducteur,
- la structure (6) annulaire allant de la première surface du substrat (5) à semi-conducteur jusqu'à la surface de la couche (10) épitaxiale étant du premier type de conductivité,
- qui comporte une structure (11, 12) de collecteur qui entoure au moins partiellement, mais non pas entièrement, la structure (6) annulaire, qui va de la surface du substrat (5) semi-conducteur jusqu'à la surface de la couche (10) épitaxiale et qui est du deuxième type de conductivité,
- dans lequel le substrat (5) à semi-conducteur est relié à un potentiel de référence,
caractérisé en ce que la structure (11, 12) de collecteur est reliée à proximité immédiate de la structure (11, 12) de collecteur, par l'intermédiaire d'une première surface (19) de contact prévue à la surface, à une deuxième surface (18) de contact, prévue à la surface et reliée au substrat (5) par l'intermédiaire de la structure (6) annulaire, et en ce que le substrat (5) semi-conducteur est relié à la masse en un point éloigné de la structure (6) annulaire.

2. Montage intégré suivant la revendication 1, caractérisé en ce que la structure (11, 12) de collecteur est plus fortement dopée que la couche (10) épitaxiale.

3. Montage intégré suivant l'une des revendications 1 à 2, caractérisé en ce que la structure de collecteur est constituée d'une couche (12) enterrée, qui est montée entre le substrat (5) semi-conducteur et la couche (10) épitaxiale, et d'une zone (11) qui va de la couche enterrée jusqu'à la surface de la couche (10) épitaxiale.
